(19) **Europäisches Patentamt**
**European Patent Office**
**Office européen des brevets**

(11) **EP 3 640 822 A1**

(12) **EUROPEAN PATENT APPLICATION**
published in accordance with Art. 153(4) EPC

(43) Date of publication:
**22.04.2020 Bulletin 2020/17**

(51) Int Cl.:
*G06F 17/10* (2006.01)    *G05B 13/02* (2006.01)

(21) Application number: **17913138.8**

(86) International application number:
**PCT/JP2017/021964**

(22) Date of filing: **14.06.2017**

(87) International publication number:
**WO 2018/229898 (20.12.2018 Gazette 2018/51)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**MA MD**

(71) Applicant: **Mitsubishi Electric Corporation**
**Chiyoda-ku**
**Tokyo 100-8310 (JP)**

(72) Inventors:
- **KANAI, Yurika**
  **Tokyo 100-8310 (JP)**
- **SAITO, Mitsunori**
  **Tokyo 100-8310 (JP)**

(74) Representative: **Zech, Stefan Markus**
**Meissner Bolte Patentanwälte**
**Rechtsanwälte Partnerschaft mbB**
**Postfach 86 06 24**
**81633 München (DE)**

(54) **STATE ESTIMATION DEVICE**

(57) A state estimation device receives, as inputs, an output from a target system and a nonlinear model that is a modeled target system, and estimates a state of the target system by using an extended Kalman filter. The nonlinear model includes a nonlinear continuous-time state equation. The device includes a state-and-error estimation unit that, on the basis of an observation equation of the nonlinear model, obtains an estimated state value and an estimated value of an error covariance matrix of the estimated state value, the estimated state value being indicative of an estimated state of the target system at a certain time point. The state estimation device also includes a state-equation discretization unit that obtains a discrete-time state equation by discretizing the nonlinear continuous-time state equation on the basis of the estimated state value at this time point, by using a quadratic or higher-order integration technique. The device further includes a state-equation linearization unit that obtains an approximate value of a Jacobian at this time point by using the discrete-time state equation at this time point and a difference method. The device still further includes a state-and-error prediction unit that predicts, from the approximate value of the Jacobian, the error covariance matrix provided after a lapse of an infinitesimal time period since this time point, and predicts, from the discrete-time state equation, the state provided after a lapse of the infinitesimal time period since this time point.

EP 3 640 822 A1

**Description**

Field

The present invention relates to a state estimation device that estimates a state or parameter of a target system.

Background

As one example of a conventional state estimation device for a nonlinear system, Non-Patent Literature 1 discloses a state estimation device that uses an extended Kalman filter (EKF). Extended Kalman filter is used for estimation of an internal state of a system on the basis of both an output from a target system and a nonlinear discrete-time system that is the modeled target system. In addition, when that system has an unknown parameter, the system is converted into an expanded system containing the unknown parameter as a state, and an extended Kalman filter is then applied thereto to estimate the state and the parameter. For such extended Kalman filter to be applied to a nonlinear system, the system is linearized using first-order Taylor approximation, which requires the Jacobian of a state equation or observation equation. Moreover, as the target system is a nonlinear discrete-time system, the state equation should be discretized beforehand if the state equation is given in continuous time.

For example, Patent Literature 1 discloses a technology that, where the target system is represented as a nonlinear continuous-time system, discretizes the target system beforehand by using an Euler method, and then applies an extended Kalman filter to thereby estimate the state and an unknown parameter.

In other words, where the target system is the nonlinear discrete-time system and the state equation is given in continuous time, the use of an extended Kalman filter requires the discretization. The process for estimating the state by using an extended Kalman filter needs calculation of the Jacobian of the state equation.

Citation List

Patent Literature

Patent Literature 1: Japanese Patent Application Laid-open No. 2005-248946

Non-Patent Literature

Non-Patent Literature 1: Takashi YAHAGI, "Kalman Filter and Adaptive Signal Processing", Corona publishing, Dec. 2005, pp.48-51

Summary

Technical Problem

Unfortunately, the conventional technology described above has difficulties in calculating a Jacobian in a case in which a quadratic or higher-order discretization technique is used for discretization of a continuous-time state equation. To address this issue, the discretization needs to be performed using an Euler method that can analytically derive a Jacobian. However, such an Euler method, which provides accuracy of first-order approximation, poses a problem of only conducting the estimation with low accuracy due to a large discretization error in a case in which the target is formulated by a continuous-time state equation.

The present invention has been made in view of the foregoing, and it is an object of the present invention to provide a state estimation device capable of estimating a state with high accuracy by using an extended Kalman filter in a case in which the state equation of a target system is a nonlinear continuous-time function.

Solution to Problem

To solve the above problem and achieve the object, the present invention provides a state estimation device to receive, as inputs, an output from a target system and a nonlinear model for estimating a state of the target system by using an extended Kalman filter, the nonlinear model being a modeled target system, wherein the nonlinear model includes a nonlinear continuous-time state equation, the state estimation device comprising: a state-and-error estimation unit to, on a basis of an observation equation of the nonlinear model, obtain an estimated state value and an estimated value of an error covariance matrix of the estimated state value, the estimated state value estimating a state of the target system at a certain time point; a state-equation discretization unit to obtain a discrete-time state equation by discretizing the nonlinear continuous-time state equation on the basis of the estimated state value at the time point, by using a quadratic or higher-order integration technique; a state-equation linearization unit to obtain an approximate value of a Jacobian at the time point by using the discrete-time state equation at the time point and a difference method; and a state-and-error prediction unit to predict, from the approximate value of the Jacobian, the error covariance matrix provided after a lapse of an infinitesimal time period since the time point, and to predict, from the discrete-time state equation, the state provided after a lapse of the infinitesimal time period since the time point.

Advantageous Effects of Invention

The state estimation device according to the present invention is capable of estimating the state with the high accuracy by using an extended Kalman filter in a case in which the state equation of the target system is the nonlinear continuous-time function.

Brief Description of Drawings

FIG. 1 is a block diagram illustrating an outline of the overall configuration of a state estimation device according to a first embodiment.
FIG. 2 is a block diagram illustrating details of the state-and-error prediction unit illustrated in FIG. 1.
FIG. 3 is a block diagram illustrating a hardware configuration of the state estimation device illustrated in FIG. 1.
FIG. 4 is a flowchart illustrating an operation of the state estimation device according to the first embodiment.
FIG. 5 is a block diagram illustrating an outline of the overall configuration of a state estimation device according to a second embodiment.
FIG. 6 is a flowchart illustrating an operation of the state estimation device according to the second embodiment.
FIG. 7 is a block diagram illustrating an outline of the overall configuration of a state estimation device according to a third embodiment.
FIG. 8 is a block diagram illustrating an outline of the overall configuration of a state estimation device according to a fourth embodiment.

Description of Embodiments

A state estimation device according to embodiments of the present invention will be described in detail below with reference to the drawings. Note that these embodiments are not intended to limit the scope of this invention.
Note that, in the description below, the parameters are vector values except for the time t and the scalar value $\varepsilon$. However, no particular distinction is made therebetween in the specification, but a vector value is indicated in bold in a mathematical formula. In addition, temporal differentiation is expressed as $(d/dt)x$ in the specification, but is indicated by a dot above the applicable letter in a mathematical formula. Furthermore, a predicted value and an estimated value are indicated by a notation of "(hat)" in the specification, but by a hat symbol above the applicable letter in a mathematical formula. A state value or an equation of an expanded system model is indicated by a notation of "(tilde)", but by a tilde above the applicable letter in a mathematical formula.

First Embodiment

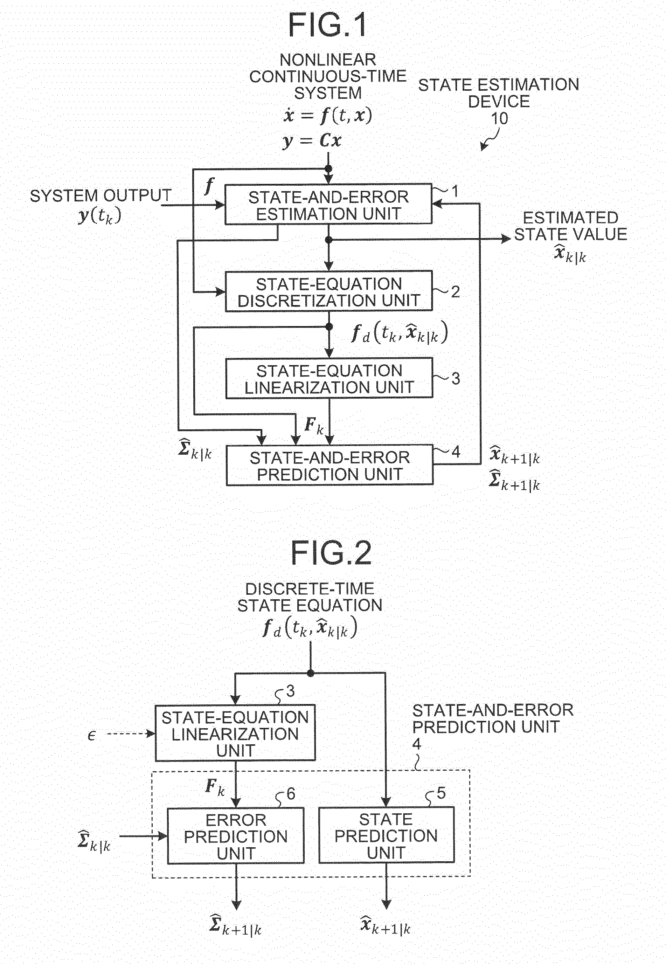

FIG. 1 is a block diagram illustrating an outline of the overall configuration of a state estimation device according to this embodiment. A state estimation device 10 illustrated in FIG. 1 includes a state-and-error estimation unit 1, a state-equation discretization unit 2, a state-equation linearization unit 3, and a state-and-error prediction unit 4. The state estimation device according to this embodiment receives, as inputs, a target-system nonlinear continuous-time state equation $(d/dt)x=f(t, x)$, a linear observation equation $y=Cx$, and a system output $y(t_k)$ at each time point. The state estimation device uses a system noise covariance matrix Q and an observation noise covariance matrix R, both of which are design parameters.
The state-and-error estimation unit 1 provides an estimated value $x_{k|k}$ (hat) of a current state and an estimated value $\Sigma_{k|k}$ (hat) of a current error covariance matrix, on the basis of: a coefficient C of the linear observation equation; the system output $y(t_k)$ at a current time $t_k$; the observation noise covariance matrix R; and a predicted current state value $x_{k|k-1}$ (hat) and a predicted current error covariance matrix value $\Sigma_{k|k-1}$ (hat) both of which were calculated at a previous time point.
The state-equation discretization unit 2 outputs a discrete-time state equation $f_d(t_k, x_{k|k}$ (hat)), which has been discretized using a fourth-order Runge-Kutta method, on the basis of the nonlinear continuous-time state equation f(t, x) and the current estimated state value $x_{k|k}$ (hat).

The state-equation linearization unit 3 calculates, from the discrete-time state equation $f_d(t_k, x_{k|k}$ (hat)), an approximate value of the Jacobian $\partial f_d(t, x)/\partial x^T|t=t_k$, $x=x_{k|k}$ (hat) of the state equation by using a difference method. Note that the suffix T indicates a transposed matrix.

FIG. 2 is a block diagram illustrating details of the state-and-error prediction unit 4 illustrated in FIG. 1. The state-and-error prediction unit 4 illustrated in FIG. 2 includes a state prediction unit 5 and an error prediction unit 6.

The state prediction unit 5 outputs the discrete-time state equation $f_d(t_k, x_{k|k}$ (hat)) as the predicted state value $x_{k+1|k}$ (hat) for a next time point. From $\partial f_d(t, x)/\partial x^T|t=t_k$, $x=x_{k|k}$ (hat) (i.e., the Jacobian $F_k$ of the state equation), the estimated current error covariance matrix value $\Sigma_{k|k}$ (hat), and the system noise covariance matrix Q, the error prediction unit 6 calculates a predicted value of the error covariance matrix $\Sigma_{k+1|k}$ (hat) for the next time point.

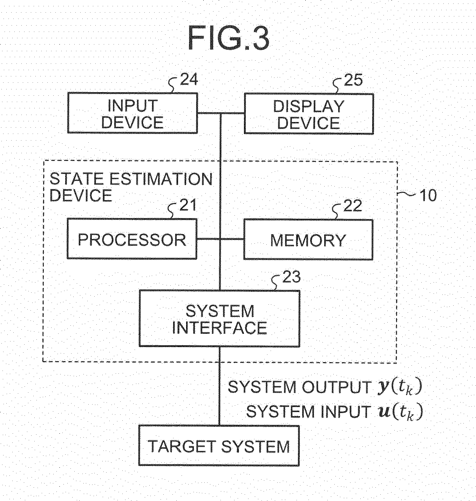

FIG. 3 is a block diagram illustrating a hardware configuration of the state estimation device 10 illustrated in FIG. 1. The state estimation device 10 illustrated in FIG. 3 includes a processor 21, a memory 22, and a system interface 23. The processor 21 performs state estimation. The memory 22 stores a program and data. The system interface 23 reads an output from the target system. The state estimation device 10 is connected to an input device 24 and a display device 25. The input device 24 receives inputs of initial values and design parameters. The display device 25 is an example of a unit for outputting an estimation result. The processor 21 executes a program stored in the memory 22 to calculate an estimated state value of the target system on the basis of: initial values and design parameters that are set via the input device 24; and an output value from the target system obtained via the system interface 23. The estimated state value output from the processor 21 is displayed on the display device 25. The processor 21 is, for example, a central processing unit (CPU). The memory 22 is, for example, a random access memory (RAM), a read-only memory (ROM), or a flash memory.

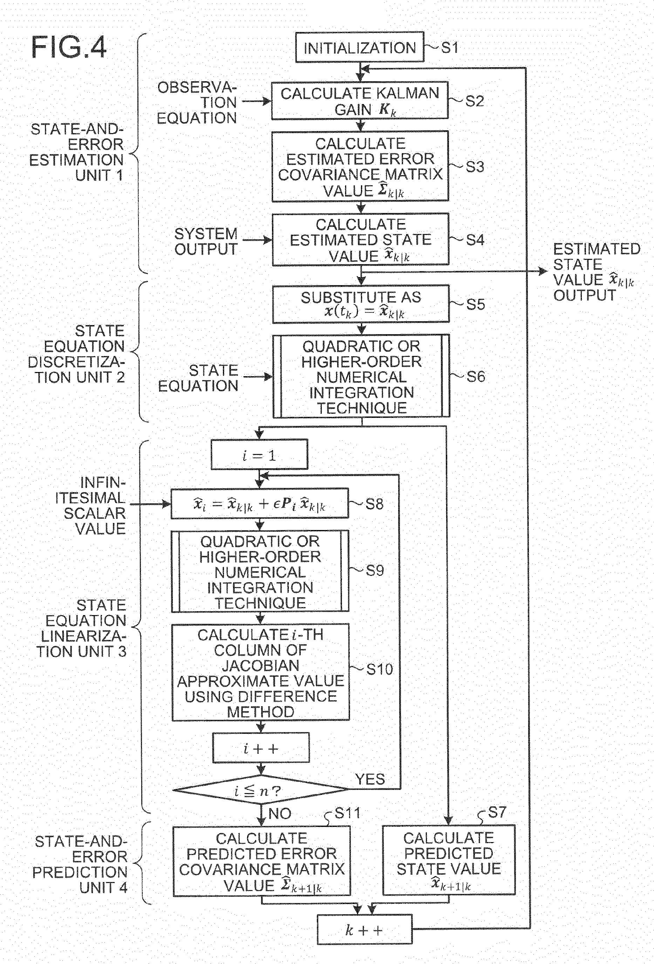

FIG. 4 is a flowchart illustrating an operation of the state estimation device according to this embodiment. Assume that the nonlinear model of the target system can be expressed by the nonlinear state equation and the linear observation equation of Formula (1) below.

[Formula 1]

$$\text{State equation}: \dot{x}(t) = f\big(t, x(t)\big)$$

$$\text{Observation equation}: y(t) = Cx$$

$$\text{where State vector}: x \in \mathbb{R}^{n \times 1}$$

$$\text{System output}: y \in \mathbb{R}^{q \times 1}$$

$$\text{Observation matrix}: C \in \mathbb{R}^{q \times n} \qquad (1)$$

In addition, the state value and the error covariance matrix value at the time $t_k$ estimated on the basis of the output value $y(t_k)$ at the time $t_k$ are represented as $x_{k|k}$ (hat) and $\Sigma_{k|k}$ (hat), respectively. The state value and the error covariance matrix value at a next time point $t_{k+1}$ predicted on the basis of the output value $y(t_k)$ at the time $t_k$ are represented as $x_{k+1|k}$ (hat) and $\Sigma_{k+1|k}$ (hat), respectively.

First, the state-and-error estimation unit 1 performs initialization (S1). Specifically, the state-and-error estimation unit 1 provides initial values that are a predicted state value $x_{1|0}$ (hat) and a predicted error covariance matrix value $\Sigma_{1|0}$ (hat) at a state estimation start time $t_1$.

Next, the state-and-error estimation unit 1 calculates a Kalman gain $K_k$ (S2). Specifically, the state-and-error estimation unit 1 calculates a Kalman gain $K_k$ by using below Formula (2) at the time $t_k$, on the basis of: the predicted current error covariance matrix value $\Sigma_{k|k-1}$ (hat) calculated at a previous time point $t_{k-1}$; the coefficient C of the linear observation equation; and the observation noise covariance matrix R. Note here that $\Sigma_{k|k-1}$ (hat) is an n×n matrix, R is a q×q matrix, and $K_k$ is an n×q matrix. Note that the suffix "-1" indicates an inverse matrix.

[Formula 2]

$$K_k = \widehat{\Sigma}_{k|k-1} C^T \big(C \widehat{\Sigma}_{k|k-1} C^T + R\big)^{-1} \qquad (2)$$

Next, the state-and-error estimation unit 1 calculates the estimated error covariance matrix value $\Sigma_{k|k}$ (hat) (S3). Specifically, the state-and-error estimation unit 1 calculates the current estimated error covariance matrix value $\Sigma_{k|k}$ (hat) by using below Formula (3). Formula (3) represents a difference between the predicted error covariance matrix value $\Sigma_{k|k-1}$ (hat) and a matrix that is a product obtained by multiplying this predicted value $\Sigma_{k|k-1}$ (hat) by both the Kalman gain $K_k$ and the coefficient C of the linear observation equation. Note that $\Sigma_{k|k}$ (hat) is an n×n matrix.
[Formula 3]

$$\widehat{\Sigma}_{k|k} = \widehat{\Sigma}_{k|k-1} - K_k C \widehat{\Sigma}_{k|k-1} \qquad (3)$$

Then, the state-and-error estimation unit 1 calculates the estimated state value $x_{k|k}$ (hat) (S4). Specifically, the state-and-error estimation unit 1 calculates the current estimated state value $x_{k|k}$ (hat) by using below Formula (4). Formula (4) represents a sum of the predicted state value $x_{k|k-1}$ (hat) and a value that is obtained by multiplying a difference by the Kalman gain $K_k$, the difference being obtained by subtracting, from the current system output $y(t_k)$, the system output $y_{k|k-1}$ (hat) predicted using the linear observation equation. Note that $x_{k|k}$ (hat) is an n×1 matrix.
[Formula 4]

$$\widehat{x}_{k|k} = \widehat{x}_{k|k-1} + K_k \big( y(t_k) - \widehat{y}_{k|k-1} \big) = \widehat{x}_{k|k-1} + K_k \big( y(t_k) - C \widehat{x}_{k|k-1} \big) \qquad (4)$$

In the state-equation discretization unit 2, the state $x(t_{k+1})$ for the next time point is expressed by below Formula (5) representing a sum of the current state $x(t_k)$ and an integral value of the state equation from the time $t_k$ to the time $t_{k+1}$.
[Formula 5]

$$x(t_{k+1}) = x(t_k) + \int_{t_k}^{t_{k+1}} f\big(t, x(t)\big) dt \qquad (5)$$

Therefore, the state equation discretization unit 2 calculates an approximate value of the nonlinear discrete-time state equation $x(t_{k+1}) = f_d(t_k, x(t_k))$ by using a quadratic or higher-order integration technique. The quadratic or higher-order numerical integration technique is, for example, a calculation technique using a fourth-order Runge-Kutta method as discussed below.

First, $\alpha = f(t_k, x(t_k))$ is calculated from the current state $x(t_k)$.

Next, $\beta = x(t_k) + (\Delta T/2)\alpha$ is calculated using the result of calculation of this $\alpha$ and a time interval $\Delta T = t_{k+1} - t_k$.

Then, $\gamma = f(t_k + (\Delta T/2), \beta)$ is calculated using the result of calculation of this $\beta$.

Then, $\lambda = x(t_k) + (\Delta T/2)\gamma$ is calculated using the result of calculation of this $\gamma$.

Then, $\zeta = f(t_k + (\Delta T/2), \lambda)$ is calculated using the result of calculation of this $\lambda$.

Then, $\eta = x(t_k) + \Delta T \zeta$ is calculated using the result of calculation of this $\zeta$.

Then, $\xi = f(t_{k+1}, \eta)$ is calculated using the result of calculation of this $\eta$.

Then, the discrete-time state equation $f_d(t_k, x(t_k)) = x(t_k) + (\Delta T/6)(\alpha + 2(\gamma + \zeta) + \xi)$ is calculated.

The state-equation discretization unit 2 then substitutes $x_{k|k}$ (hat) for $x(t_k)$ (S5), and performs a calculation using a quadratic or higher-order numerical integration technique (S6). Specifically, the state-equation discretization unit 2 substitutes the current estimated state value $x_{k|k}$ (hat) for the current state $x(t_k)$, and calculates the discrete-time state equation $f_d(t_k, x_{k|k}$ (hat)) by using the above Runge-Kutta method.

The state prediction unit 5 calculates the predicted state value $x_{k+1|k}$ (hat) (S7). Specifically, as shown by below Formula (6), the state prediction unit 5 outputs the value of the discrete-time state equation $f_d(t_k, x_{k|k}$ (hat)) as the predicted state value $x_{k+1|k}$ (hat) for the next time point $t_{k+1}$.
[Formula 6]

$$\widehat{x}_{k+1|k} = f_d\big(t_k, \widehat{x}_{k|k}\big) \qquad (6)$$

The state-equation linearization unit 3 calculates the approximate Jacobian value $F_k$ on the basis of the discrete-time state equation $f_d$ and a predetermined infinitesimal scalar value $\varepsilon$ by using a difference method. Note that $F_k$ is an

n×n matrix. The state-equation linearization unit 3 first calculates a value $x_i$ (hat) (S8). Specifically, as shown by below Formula (7), the state-equation linearization unit 3 multiplies only the i-th component of the state by (1+ε) with respect to the current estimated state value $x_{k|k}$ (hat), thereby providing the resulting value $x_i$ (hat).

[Formula 7]

$$\hat{x}_i = \hat{x}_{k|k} + \epsilon P_i \hat{x}_{k|k} \qquad (7)$$

where $P_i \in \mathbb{R}^{n \times n}$ :

$n \times n$ matrix having (i, i) elements being 1, and the other elements being 0

The state-equation linearization unit 3 then performs a calculation using a quadratic or higher-order numerical integration (S9), and calculates the i-th column of the Jacobian approximate value by using a difference method (S10). Specifically, the state-equation linearization unit 3 calculates the value of the discrete-time state equation on the basis of $x_i$ (hat) by using the above described numerical integration technique. Then, as shown by below Formula (8), the state-equation linearization unit 3 approximates the i-th column (i=1, 2, ..., n) of the Jacobian by providing a value obtained by dividing, by a value $εx_{k|k}(i)$ (hat), the difference from the discrete-time state equation $f_d(t_k, x_{k|k}$ (hat)) for the current estimated state value $x_{k|k}$ (hat), the value $εx_{k|k}(i)$ (hat) being obtained by multiplying the i-th component of the current estimated state value by ε. Note that this operation is consecutively repeated from i=1 to i=n.

[Formula 8]

$$\left. \frac{\partial f_d}{\partial x(i)} \right|_{t=t_k, x=\hat{x}_{k|k}} \approx \frac{f_d(t_k, \hat{x}_i) - f_d(t_k, \hat{x}_{k|k})}{\epsilon \hat{x}_{k|k}(i)} = F_k(:, i), \quad (i = 1, 2, \cdots, n) \qquad (8)$$

Then, the error prediction unit 6 calculates the predicted error covariance matrix value $\Sigma_{k+1|k}$ (hat) (S11). Specifically, the error prediction unit 6 calculates the error covariance matrix $\Sigma_{k+1|k}$ (hat) for the next time point on the basis of: the approximate Jacobian value $F_k$; the current estimated error covariance matrix value $\Sigma_{k|k}$ (hat); and the system noise covariance matrix Q, by using Formula (9) below. Note that Q is an n×n matrix.

[Formula 9]

$$\hat{\Sigma}_{k+1|k} = F_k \hat{\Sigma}_{k|k} F_k^T + Q \qquad (9)$$

The state estimation device 10 then advances the time from $t_k$ to $t_{k+1}$, and thus repeats the above steps S2 to S11 to output the estimated state value at each time point. The calculation operations at the above steps are performed in the processor 21. The calculated values obtained at the corresponding steps, such as the Kalman gain $K_k$, the estimated values $x_{k|k}$ (hat) and $\Sigma_{k|k}$ (hat), the predicted values $x_{k|k-1}$ (hat) and $\Sigma_{k|k-1}$ (hat), the discrete-time state equation $f_d$, and the approximate Jacobian value $F_k$ of the state equation are stored in the memory 22 and are read from the memory 22 and used at the corresponding steps.

As described above, even when the state equation of a target system is given by a nonlinear continuous-time function, the state estimation device according to this embodiment enables a high-order, i.e., quadratic or higher-order, integration technique to be applied to discretization of the state equation because an approximate Jacobian value is calculated on the basis of the estimated state value at each time point. This can reduce the discretization error in the process of state estimation that uses an extended Kalman filter, and can thus improve state estimation accuracy.

One known state estimation device for a nonlinear system other than one that uses an extended Kalman filter is a state estimation device that uses an unscented Kalman filter. Use of an extended Kalman filter enables the state estimation device according to the present invention to reduce the number of design parameters requiring adjustment, and also reduce the amount of calculation as compared to when an unscented Kalman filter is used. Note that the state estimation device of this embodiment uses a fourth-order Runge-Kutta method for the approximation relating to Formula (5) described above, but the present invention is not limited thereto. An integration technique having accuracy of quadratic or higher-order approximation, such as Heun's method, can be satisfactorily used.

The infinitesimal scalar value ε which the state-equation linearization unit 3 uses in a difference method is preferably as low a value as possible depending on the target system, and may be externally changeable via the input device 24 depending on an estimation result displayed on the display device 25. Externally changing the infinitesimal scalar value ε to a minimum value without causing an anomaly such as divergence of an estimation result can reduce the error caused by approximation of the Jacobian. In addition, instead of using an infinitesimal scalar value ε, a matrix of vector n×1 may be used as the parameter ε, such that the calculation is performed using an infinitesimal value ε(i) that is partially or wholly different across the states, as given by Formula (10) below.

[Formula 10]

$$\left.\frac{\partial f_d}{\partial x(i)}\right|_{t=t_k, x=\hat{x}_{k|k}} \approx \frac{f_d\left(t_k, \hat{x}_{k|k} + \epsilon(i)P_i\hat{x}_{k|k}\right) - f_d\left(t_k, \hat{x}_{k|k}\right)}{\epsilon(i)\hat{x}_{k|k}(i)} = F_k(:,i), \quad (i = 1,2,\cdots,n) \qquad (10)$$

Moreover, if a relationship of $x_{k|k}(i)$ (hat)≈0 applies, Formula (11) below may be used instead, which uses an infinitesimal value ε' temporarily or for the entire period.

[Formula 11]

$$\left.\frac{\partial f_d}{\partial x(i)}\right|_{t=t_k, x=\hat{x}_{k|k}} \approx \frac{f_d\left(t_k, \hat{x}_{k|k} + \epsilon'E_i\right) - f_d\left(t_k, \hat{x}_{k|k}\right)}{\epsilon'} = F_k(:,i) \qquad (11)$$

where $E_i \in \mathbb{R}^{n\times1}$ :

$n$-dimensional vector having an $i$-th component being 1, and the other elements being 0

Second Embodiment

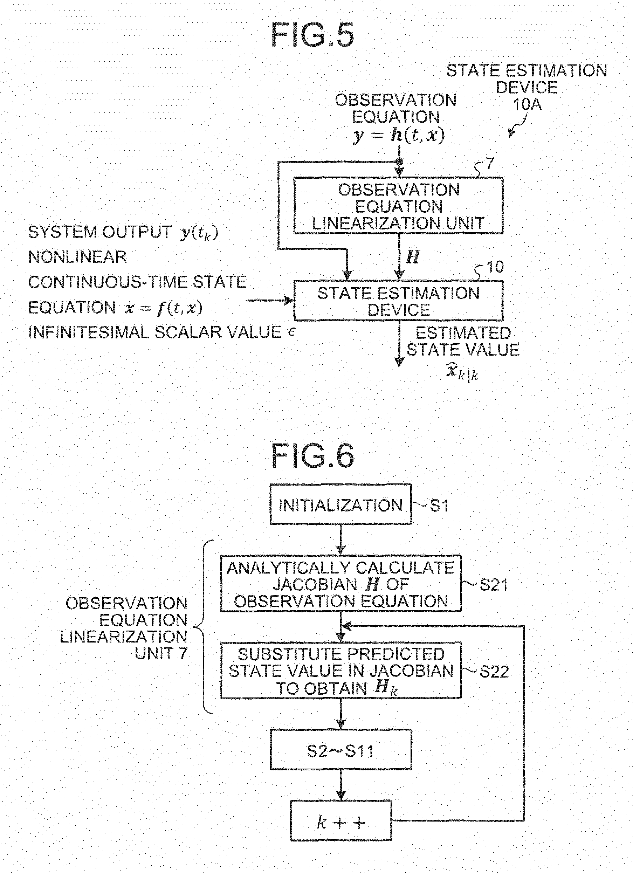

FIG. 5 is a block diagram illustrating an outline of the overall configuration of a state estimation device according to this embodiment. A state estimation device 10A illustrated in FIG. 5 includes an observation-equation linearization unit 7 and the state estimation device 10 illustrated in FIG. 1. Note that description of components and operations similar to those of the first embodiment will be omitted. For the state estimation device according to this embodiment, a target system is represented by the nonlinear continuous-time state equation (d/dt)x=f(t, x) and a nonlinear observation equation y=h(t, x). The state estimation device 10A receives, as inputs, these equations and the system output $y(t_k)$ at each time point, and uses the system noise covariance matrix Q and the observation noise covariance matrix R both of which are design parameters. The nonlinear observation equation y=h(t, x) is used in place of the linear observation equation y=Cx.

The observation-equation linearization unit 7 analytically calculates a Jacobian H from the observation equation h(t, x). From the Jacobian $H_k$ of the observation equation, the system output $y(t_k)$, the predicted current state value $x_{k|k-1}$ (hat), and $\Sigma_{k|k-1}$ (hat), the state-and-error estimation unit 1 provides the current estimated value $x_{k|k}$ (hat) of the state and the current estimated valus $\Sigma_{k|k}$ (hat) of the error covariance matrix. The state-equation discretization unit 2, the state-equation linearization unit 3, and the state-and-error prediction unit 4 operate similarly to the first embodiment.

FIG. 6 is a flowchart illustrating an operation of the state estimation device according to this embodiment. Steps S1 and S2 to S11 of the flowchart of FIG. 6 are those which are discussed with reference to FIG. 4. Note that this mention of steps S2 to S11 includes the operations of i=1 and i++. Assume that the nonlinear model of the target system can be expressed by the nonlinear continuous-time state equation and the nonlinear observation equation of Formula (12) below.

[Formula 12]

$$\text{State equation} : \dot{x}(t) = f\left(t, x(t)\right)$$

$$\text{Observation equation} : y(t) = h\left(t, x(t)\right)$$

$$\text{where State vector} : x \in \mathbb{R}^{n\times1}$$

$$\text{System output} : y \in \mathbb{R}^{q\times1} \qquad (12)$$

The operation of the state estimation device 10A illustrated in FIG. 6 further includes an operation of the observation-equation linearization unit 7 between step S1 and step S2 of the flowchart illustrated in FIG. 4. The observation-equation linearization unit 7 analytically calculates the Jacobian H of the observation equation, as shown by below Formula (13) (S21). Note that H is a q×n matrix.
[Formula 13]

$$H = \frac{\partial h}{\partial x^T} \quad (13)$$

Next, the observation-equation linearization unit 7 substitutes, at each time point, the predicted state value $x_{k|k-1}$ (hat) for the current time $t_k$ in the Jacobian of the observation equation as shown by below Formula (14), and thus obtains the current Jacobian $H_k$ of the observation equation (S22). Note that $x_{k|k-1}$ (hat) is an n×1 matrix, and $H_k$ is a q×n matrix.
[Formula 14]

$$H_k = \frac{\partial h}{\partial x^T}\bigg|_{t=t_k, x=\hat{x}_{k|k-1}} \quad (14)$$

From Formula (14), the observation equation can be approximated by a product obtained by multiplying the state by the Jacobian in a vicinity of the predicted current state value $x_{k|k-1}$ (hat), as shown by below Formula (15).
[Formula 15]

$$y(t_k) \approx H_k x(t_k) \quad (15)$$

Thus, state estimation is performed by replacing the coefficient C of the observation equation in the first embodiment with the Jacobian $H_k$, and by using the original nonlinear function $h(t_k, x_{k|k-1}$ (hat)) for the purpose of calculation of the predicted output value $y_{k|k-1}$ (hat). The calculation operations at the above steps are performed in the processor 21. The calculated values obtained at the corresponding steps, such as the Kalman gain $K_k$, the estimated values $x_{k|k}$ (hat) and $\Sigma_{k|k}$ (hat), the predicted values $x_{k|k-1}$ (hat) and $\Sigma_{k|k-1}$. (hat), the discrete-time state equation $f_d$, and the approximate Jacobian value $F_k$ of the state equation are stored in the memory 22, and are read from the memory 22 and used at the corresponding steps.
As described above, even when the state equation of a target system is a nonlinear continuous-time function, and the observation equation is given by a nonlinear function, the state estimation device according to this embodiment can reduce the amount of calculation by analytically calculating the Jacobian of the observation equation that needs no discretization. Further, the state estimation device according to this embodiment enables a high-order, i.e., quadratic or higher-order, integration technique to be applied to discretization of the state equation because an approximate value of the Jacobian of the state equation is calculated on the basis of the estimated state value at each time point. As a result, it becomes possible to reduce the discretization error in the process of state estimation that uses an extended Kalman filter, and thus improve state estimation accuracy.

Third Embodiment

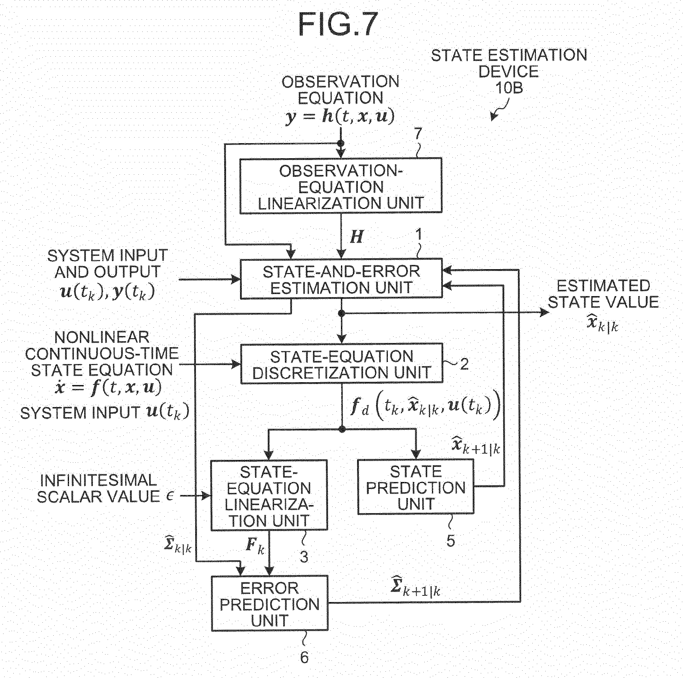

FIG. 7 is a block diagram illustrating an outline of the overall configuration of a state estimation device according to this embodiment. A state estimation device 10B illustrated in FIG. 7 includes the observation-equation linearization unit 7, the state-and-error estimation unit 1, the state-equation discretization unit 2, the state-equation linearization unit 3, the state prediction unit 5, and the error prediction unit 6. Note that description of components and operations similar to those of the first and second embodiments will be omitted. The hardware configuration is that which is discussed with reference to FIG. 3, and the flowchart is that which is discussed with reference to FIG. 6.
The state estimation device according to this embodiment receives, as inputs, a target-system nonlinear continuous-time state equation (d/dt)x=f(t, x, u), an observation equation y=h(t, x, u), and system input and output $u(t_k)$ and $y(t_k)$ at each time point. The state estimation device according to this embodiment uses design parameters: the system noise covariance matrix Q; the observation noise covariance matrix R; and the infinitesimal scalar value ε to be used in a difference method. The nonlinear observation equation y=h(t, x, u) is used in place of the linear observation equation y=Cx.

The observation-equation linearization unit 7 analytically calculates the Jacobian H from the observation equation h(t, x, u). From the Jacobian $H_k$ of the observation equation, system output $y(t_k)$, the predicted current state value $x_{k|k-1}$ (hat), and the predicted current error covariance matrix value $\Sigma_{k|k-1}$ (hat), the state-and-error estimation unit 1 provides the current estimated value $x_{k|k}$ (hat) of the state and the current estimated value $\Sigma_{k|k}$ (hat) of the error covariance matrix.

The state-equation discretization unit 2 outputs a discrete-time state equation $f_d(t_k, x_{k|k}$ (hat), $u(t_k))$, which has been discretized using a fourth-order Runge-Kutta method, on the basis of: the nonlinear continuous-time state equation (d/dt)x=f(t, x, u); the current state and error covariance matrix $x_{k|k}$ (hat) and $\Sigma_{k|k}$ (hat); and the system input $u(t_k)$.

From the discretization-time state equation $f_d(t_k, x_{k|k}$ (hat), $u(t_k))$ and the infinitesimal scalar value $\varepsilon$, the state-equation linearization unit 3 calculates the Jacobian $\partial f_d(t, x, u)/\partial x^T|t=t_k, x=x_{k|k}$ (hat), $u=u(t_k)$ of the state equation by using a difference method. The state prediction unit 5 outputs the discretization-time state equation $f_d(t_k, x_{k|k}$ (hat), $u(t_k))$ as the predicted state value $x_{k+1|k}$ (hat) for the next time point. From the Jacobian $\partial f_d(t, x, u)/\partial x^T|t=t_k, x=x_{k|k}$ (hat), $u=u(t_k)$ of the state equation, the current estimated error covariance matrix value $\Sigma_{k|k}$ (hat), and the system noise covariance matrix Q, the error prediction unit 6 calculates the predicted error covariance matrix value $\Sigma_{k+1|k}$ (hat) for the next time point.

The state estimation device according to this embodiment will next be described in detail. First, assume that the nonlinear model of the target system can be expressed by the state equation and the observation equation of below Formula (16).

[Formula 16]

$$\text{State equation}: \dot{x}(t) = f\big(t, x(t), u(t)\big)$$

$$\text{Observation equation}: y(t) = h\big(t, x(t), u(t)\big)$$

$$\text{where State vector}: x \in \mathbb{R}^{n\times 1}$$

$$\text{System output}: y \in \mathbb{R}^{q\times 1}$$

$$\text{System input}: u \in \mathbb{R}^{m\times 1} \qquad (16)$$

The initialization operation at step S1 is similar to the initialization operation in the first embodiment. The observation-equation linearization unit 7 analytically calculates the Jacobian H of the observation equation, as shown by below Formula (17) (S21). Note that H is a q×n matrix.

[Formula 17]

$$H = \frac{\partial h}{\partial x^T} \qquad (17)$$

Next, the observation-equation linearization unit 7 substitutes, at each time point, the predicted state value $x_{k|k-1}$ (hat) and the system input $u(t_k)$ for the current time $t_k$ into the Jacobian of the observation equation, and thus obtains the current Jacobian $H_k$ as shown by below Formula (18) (S22). Note that $x_{k|k-1}$ (hat) is an n×1 matrix, and $H_k$ is a q×n matrix.

[Formula 18]

$$H_k = \frac{\partial h}{\partial x^T}\bigg|_{t=t_k, x=\hat{x}_{k|k-1}, u=u(t_k)} \qquad (18)$$

Then, as shown by below Formula (19), the state-and-error estimation unit 1 calculates the Kalman gain $K_k$ from: the predicted current error covariance matrix value $\Sigma_{k|k-1}$ (hat); the Jacobian $H_k$; and the observation noise covariance matrix R (S2).

[Formula 19]

$$K_k = \widehat{\Sigma}_{k|k-1} H_k^T \left( H_k \widehat{\Sigma}_{k|k-1} H_k^T + R \right)^{-1} \tag{19}$$

Next, the state-and-error estimation unit 1 calculates the current estimated error covariance matrix value $\Sigma_{k|k}$ (hat) as shown by below Formula (20) (S3). The the current estimated error covariance matrix value $\Sigma_{k|k}$ (hat) is the difference between the predicted error covariance matrix value $\Sigma_{k|k-1}$ (hat) and a matrix that is a product obtained by multiplying the predicted value $\Sigma_{k|k-1}$ (hat) by both the Kalman gain $K_k$ and the coefficient $H_k$ of the observation equation. Note that $\Sigma_{k|k}$ (hat) is an n×n matrix.
[Formula 20]

$$\widehat{\Sigma}_{k|k} = \widehat{\Sigma}_{k|k-1} - K_k H_k \widehat{\Sigma}_{k|k-1} \tag{20}$$

Then, the state-and-error estimation unit 1 calculates the current estimated state value $x_{k|k}$ (hat) as shown by below Formula (21) (S4). The current estimated state value $x_{k|k}$ (hat) is a sum of the predicted current state value $x_{k|k-1}$ (hat) and a product of the Kalman gain and a difference between the current system output $y(t_k)$ and the system output $y_{k|k-1}$ (hat) that is predicted using the observation equation on the basis of the predicted state value $x_{k|k-1}$ (hat) and the system input $u(t_k)$. Note that $x_{k|k}$ (hat) is an n×1 matrix.
[Formula 21]

$$\widehat{x}_{k|k} = \widehat{x}_{k|k-1} + K_k \left( y(t_k) - \widehat{y}_{k|k-1} \right)$$
$$= \widehat{x}_{k|k-1} + K_k \left( y(t_k) - h\left( t_k, \widehat{x}_{k|k-1}, u(t_k) \right) \right) \tag{21}$$

In the state-equation discretization unit 2, the state $x(t_{k+1})$ for the next time point is expressed by a sum of the current state $x(t_k)$ and an integral value of the state equation from the time $t_k$ to the time $t_{k+1}$, as shown by below Formula (22). Thus, the state-equation discretization unit 2 calculates an approximate value of the nonlinear discrete-time state equation $x(t_{k+1})=f_d(t_k, x(t_k), u(t_k))$ by using a quadratic or higher-order integration technique. The quadratic or higher-order numerical integration technique is, for example, a calculation technique using a fourth-order Runge-Kutta method that also takes into account the system input.
[Formula 22]

$$x(t_{k+1}) = x(t_k) + \int_{t_k}^{t_{k+1}} f\left( t, x(t), u(t) \right) dt \tag{22}$$

First, $\alpha=f(t_k, x(t_k), u(t_k))$ is calculated from the current state $x(t_k)$ and the system input $u(t_k)$.
Next, $\beta=x(t_k)+(\Delta T/2)\alpha$ is calculated using the result of calculation of this $\alpha$ and a time interval $\Delta T=t_{k+1}-t_k$.
Then, $\gamma=f(t_k+(\Delta T/2), \beta,, u(t_k))$ is calculated using the result of calculation of this $\beta$.
Then, $\lambda=x(t_k)+(\Delta T/2)\gamma$ is calculated using the result of calculation of this $\gamma$.
Then, $\zeta=f(t_k+(\Delta T/2), \lambda, u(t_k))$ is calculated using the result of calculation of this $\lambda$.
Then, $\eta=x(t_k)+\Delta T\zeta$ is calculated using the result of calculation of this $\zeta$.
Then, $\xi=f(t_{k+1}, \eta, u(t_k))$ is calculated using the result of calculation of this $\eta$.
Then, the discrete-time state equation $f_d(t_k, x(t_k), u(t_k))=x(t_k)+(\Delta T/6) (\alpha+2(\gamma+\zeta)+\xi)$ is calculated.
The state-equation discretization unit 2 then substitutes the current estimated state value $x_{k|k}$ (hat) for the current state $x(t_k)$ (S5), and calculates the discrete-time state equation $f_d(t_k, x_{k|k}$ (hat), $u(t_k))$ by using the above Runge-Kutta method (S6).
As shown by below Formula (23), the state prediction unit 5 outputs the discrete-time state equation $f_d(t_k, x_{k|k}$ (hat), $u(t_k))$ as the predicted state value $\times_{k+1|k}$ (hat) for the next time point $t_{k+1}$ (S7).
[Formula 23]

$$\widehat{x}_{k+1|k} = f_d \left( t_k, \widehat{x}_{k|k}, u(t_k) \right) \qquad (23)$$

The state-equation linearization unit 3 calculates the approximate Jacobian value $F_k$ on the basis of the discrete-time state equation $f_d(t_k, x_{k|k}$ (hat), $u(t_k))$ and the predetermined infinitesimal scalar value $\varepsilon$, by using a difference method. Note that $F_k$ is an $n \times n$ matrix. The state-equation linearization unit 3 first calculates $x_i$ (hat) from the current estimated state value $x_{k|k}$ (hat), as shown by above Formula (7) (S8).

Next, the state-equation linearization unit 3 calculates the value of the discrete-time state equation on the basis of $x_i$ (hat) by using the numerical integration technique described above (S9). Then, as shown by below Formula (24), the state-equation linearization unit 3 approximates the i-th column (i=1, 2, ..., n) of the Jacobian (S10) by providing a value obtained by dividing, by a value $\varepsilon x_{k|k}(i)$ (hat), the difference from the discrete-time state equation $f_d(t_k, x_{k|k}$ (hat), $u(t_k))$ for the current estimated state value $x_{k|k}$ (hat), the value $\varepsilon x_{k|k}(i)$ (hat) being obtained by multiplying the i-th component of the current estimated state value by $\varepsilon$.

[Formula 24]

$$\left. \frac{\partial f_d}{\partial x(i)} \right|_{t=t_k, x=\widehat{x}_{k|k}, u=u(t_k)} \approx \frac{f_d\left(t_k, \widehat{x}_i, u(t_k)\right) - f_d\left(t_k, \widehat{x}_{k|k}, u(t_k)\right)}{\varepsilon \widehat{x}_{k|k}(i)} = F_k(:,i), \quad (i = 1,2,\cdots,n) \qquad (24)$$

where $P_i \in \mathbb{R}^{n \times n}$ :

$n \times n$ matrix having (i, i) elements being 1, and the other elements being 0

The error prediction unit 6 then calculates the error covariance matrix $\Sigma_{k+1|k}$ (hat) for the next time point, on the basis of: the approximate Jacobian value $F_k$; the current estimated error covariance matrix value $\Sigma_{k|k}$ (hat); and the system noise covariance matrix Q, by using below Formula (25) (S11). Note that Q is an $n \times n$ matrix.

[Formula 25]

$$\widehat{\Sigma}_{k+1|k} = F_k \widehat{\Sigma}_{k|k} F_k^T + Q \qquad (25)$$

The calculation operations at the above steps are performed in the processor 21. The calculated values obtained at the corresponding steps, such as the Kalman gain $K_k$, the estimated values $x_{k|k}$ (hat) and $\Sigma_{k|k}$ (hat), the predicted values $x_{k|k-1}$ (hat) and $\Sigma_{k|k-1}$ (hat), the discrete-time state equation $f_d$, and the approximate Jacobian value $F_k$ of the state equation are stored in the memory 22, and are read from the memory 22 and used at the corresponding steps.

As described above, even when a target system receives an input, and the state equation of the target system is given by a nonlinear continuous-time function, the state estimation device according to this embodiment enables a high-order, i.e., quadratic or higher-order, integration technique to be applied to discretization of the state equation because an approximate Jacobian value is calculated on the basis of the estimated state value at each time point. This can reduce the discretization error in the process of state estimation that uses an extended Kalman filter, and can thus improve state estimation accuracy.

Note that the state estimation device according to this embodiment uses a fourth-order Runge-Kutta method for the approximation relating to Formula (22) described above, but the present invention is not limited thereto. An integration technique having accuracy of quadratic or higher-order approximation, such as Heun's method, can be satisfactorily used.

Although this embodiment is based on the assumption that the observation equation of the target system is nonlinear, the present invention is also applicable to a case in which the observation equation is a linear function. The case in which the observation equation is a linear function can be addressed by omitting the observation-equation linearization unit 7, and using $H_k$ that is the coefficient matrix for the state in the observation equation.

The infinitesimal scalar value $\varepsilon$ used in a difference method is preferably as low a value as possible depending on the target system, and may be externally changeable via the input device 24 depending on an estimation result displayed on the display device 25. Externally changing the infinitesimal scalar value $\varepsilon$ to a minimum value without causing an anomaly such as divergence of the estimation result can reduce the error caused by approximation of the Jacobian. In addition, instead of using an infinitesimal scalar value $\varepsilon$, a matrix of vector $n \times 1$ may be used as the parameter ε, such that the calculation is performed using an infinitesimal value ε(i) that is partially or wholly different across the states, as given by Formula (26) below.
[Formula 26]

$$F_k(:,i) = \frac{f_d\left(t_k, \hat{x}_{k|k} + \epsilon P_i \hat{x}_{k|k}, u(t_k)\right) - f_d\left(t_k, \hat{x}_{k|k}, u(t_k)\right)}{\epsilon(i)\hat{x}_{k|k}(i)}, \quad (i = 1,2,\cdots,n) \tag{26}$$

Moreover, if a relationship of $x_{k|k}$(i) (hat)≈0 applies, Formula (27) below may be used instead, which uses an infinitesimal value ε' temporarily or for the entire period.
[Formula 27]

$$F_k(:,i) = \frac{f_d\left(t_k, \hat{x}_{k|k} + \epsilon' E_i, u(t_k)\right) - f_d\left(t_k, \hat{x}_{k|k}, u(t_k)\right)}{\epsilon'} \tag{27}$$

Fourth Embodiment

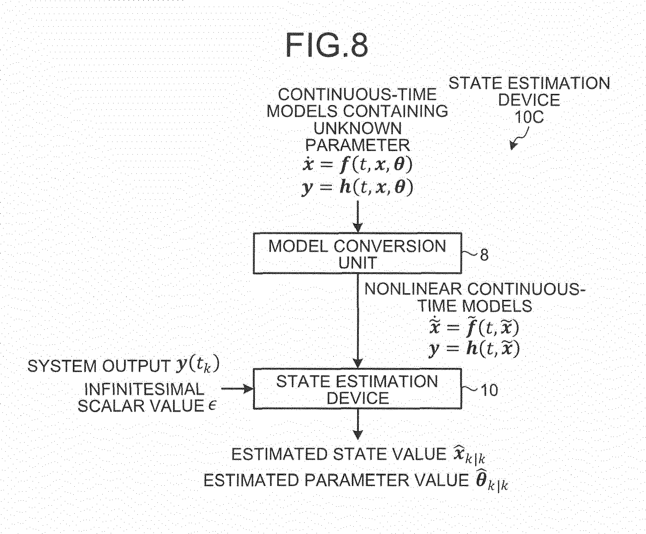

FIG. 8 is a block diagram illustrating an outline of the overall configuration of a state estimation device according to this embodiment. A state estimation device 10C illustrated in FIG. 8 includes a model conversion unit 8 and the state estimation device 10B illustrated in FIG. 7. Note that description of components and operations similar to those of the first to third embodiments will be omitted. The hardware configuration is that which is discussed with reference to FIG. 3, and the flowchart is that which is discussed with reference to FIG. 4.

The state estimation device according to this embodiment receives, as inputs, a continuous-time model (d/dt)x=f(t, x, θ) and y=h(t, x, θ) containing an unknown parameter θ of the target system, and the system output y($t_k$) at each time point. The state estimation device 10C uses design parameters: the system noise covariance matrix Q; the observation noise covariance matrix R; and the infinitesimal scalar value ε to be used in a difference method. The state estimation device 10C estimates the unknown parameter θ and the state x at the same time. The nonlinear observation equation y=h(t, x, θ) is used in place of the linear observation equation y=Cx.

The model conversion unit 8 converts the continuous-time models into respective nonlinear continuous-time models using a new state vector having therein the state x and the unknown parameter θ before conversion.

The state estimation device 10B uses, as inputs, the nonlinear continuous-time model generated by the conversion, and calculates an estimated value of the new state vector. The observation-equation linearization unit 7, the state-and-error estimation unit 1, the state-equation discretization unit 2, the state-equation linearization unit 3, the state prediction unit 5, and the error prediction unit 6 of the state estimation device 10B are identical to those of the first to third embodiments.

A process for estimating the state and the parameter by the state estimation device according to this embodiment will next be described in detail. Assume that the model of the target system can be expressed by the following continuous-time state equation and observation equation each containing an unknown parameter θ, as shown by Formula (28) below.
[Formula 28]

$$\dot{x} = f(t,x,\theta)$$
$$y = h(t,x,\theta)$$

$$\text{where State vector}: x \in \mathbb{R}^{n \times 1}$$

$$\text{System output}: y \in \mathbb{R}^{q \times 1}$$

$$\text{Unknown parameter}: \theta \in \mathbb{R}^{p \times 1} \tag{28}$$

The process includes an additional operation to be performed by the model conversion unit 8 before the initialization step (S1) in FIG. 4 or FIG. 6.

The model conversion unit 8 converts the continuous-time model of the system containing an unknown parameter θ into new nonlinear continuous-time models shown by below Formula (29) using a new state vector x (tilde)=[$x^T$ $\theta^T]^T$ having therein the state x and the unknown parameter θ before conversion. Note that x (tilde) is an (n+p)×1 matrix.
[Formula 29]

$$\dot{\tilde{x}} = \tilde{f}(t, \tilde{x})$$
$$y = h(t, \tilde{x}) \quad (29)$$

In this process, in a case in which the unknown parameter θ varies in time, the unknown parameter θ is modeled, and is set as n+1:n+p components of the function f (tilde). Alternatively, in a case in which the unknown parameter θ is constant or varies in time at a rate 10 or more times slower than the sampling rate, the n+1:n+p components of the function f (tilde) are set to zero. The subsequent operations are similar to those shown in FIG. 4, and the estimated value of the new vector x (tilde) is calculated using Formula (30) below.
[Formula 30]

$$\hat{\tilde{x}}_{k|k} = \begin{bmatrix} \hat{x}_{k|k} \\ \hat{\theta}_{k|k} \end{bmatrix} \quad (30)$$

The calculation operations at the above steps are performed in the processor 21. The calculated values obtained at the corresponding steps, such as the Kalman gain $K_k$, the estimated values $x_{k|k}$ (tilde) (hat) and $\Sigma_{k|k}$ (hat), the predicted values $x_{k|x-1}$ (tilde) (hat) and $\Sigma_{k|x-1}$ (hat), the discrete-time state equation $f_d$ (tilde), and the approximate Jacobian value $F_k$ (tilde) of the state equation are stored in the memory 22, and are read from the memory 22 and used at the corresponding steps.

As described above, even when the state equation of a target system is a continuous-time function, and contains an unknown parameter, the state estimation device according to this embodiment can estimate the state by conversion of the continuous-time model into a model having a new state having therein the state and the unknown parameter before conversion. This can reduce the discretization error, and can thus perform state estimation and parameter estimation with high accuracy.

Note that the continuous-time model containing an unknown parameter, used as inputs in this embodiment may be nonlinear or linear, and even linear continuous-time model is output as a nonlinear model from the model conversion unit. In addition, as long as the continuous-time model causes the model conversion unit to provide an output that includes a nonlinear continuous-time state equation, the unknown parameter may be contained in one or both of the state equation and the observation equation. Moreover, the continuous-time models may or may not contain a system input.

The configurations described in the foregoing embodiments are merely examples of various aspects of the present invention. These configurations may be combined with a known other technology, and moreover, a part of such configurations may be omitted and/or modified without departing from the spirit of the present invention.

Reference Signs List

1 state-and-error estimation unit; 2 state-equation discretization unit; 3 state-equation linearization unit; 4 state-and-error prediction unit; 5 state prediction unit; 6 error prediction unit; 7 observation-equation linearization unit; 8 model conversion unit; 10, 10A, 10B, 10C state estimation device; 21 processor; 22 memory; 23 system interface; 24 input device; 25 display device.

**Claims**

1. A state estimation device to receive, as inputs, an output from a target system and a nonlinear model for estimating a state of the target system by using an extended Kalman filter, the nonlinear model being a modeled target system, wherein
   the nonlinear model includes a nonlinear continuous-time state equation, the state estimation device comprising:

   a state-and-error estimation unit to, on a basis of an observation equation of the nonlinear model, obtain an estimated state value and an estimated value of an error covariance matrix of the estimated state value, the estimated state value estimating a state of the target system at a certain time point;

a state-equation discretization unit to obtain a discrete-time state equation by discretizing the nonlinear continuous-time state equation on the basis of the estimated state value at the time point, by using a quadratic or higher-order integration technique;

a state-equation linearization unit to obtain an approximate value of a Jacobian at the time point by using the discrete-time state equation at the time point and a difference method; and

a state-and-error prediction unit to predict, from the approximate value of the Jacobian, the error covariance matrix provided after a lapse of an infinitesimal time period since the time point, and to predict, from the discrete-time state equation, the state provided after a lapse of the infinitesimal time period since the time point.

2. The state estimation device according to claim 1, wherein
an infinitesimal scalar value to be used in a difference method is used as an input, and
the state-equation linearization unit obtains the approximate value of the Jacobian on the basis of the discrete-time state equation and the infinitesimal scalar value by using the difference method.

3. The state estimation device according to claim 1, wherein
an infinitesimal value vector to be used in a difference method is used as an input, and
the state-equation linearization unit obtains, from the discrete-time state equation, approximate values of partial differentiation of the state equation for each of states, on the basis of a corresponding one of elements of the infinitesimal value vector, by using the difference method.

4. The state estimation device according to any one of claims 1 to 3, wherein the observation equation of the nonlinear model is nonlinear, and comprising an observation-equation linearization unit, disposed upstream of the state-and-error estimation unit, to analytically obtain a Jacobian of the nonlinear observation equation.

5. The state estimation device according to any one of claims 1 to 4, comprising a model discretization unit to discretize the nonlinear continuous-time state equation on the basis of an input at each time point and the estimated state value of the target system, by using a quadratic or higher-order integration technique.

6. The state estimation device according to any one of claims 1 to 5,
wherein the target system is modeled into a continuous-time model that contains an unknown parameter,
the device comprising a model conversion unit to convert the continuous-time model into an expanded system nonlinear continuous-time model for a new state represented by a vector having the unknown parameter and the state before the conversion, and
wherein the nonlinear model received as an input is the expanded system nonlinear continuous-time model obtained by the conversion by the model conversion unit.

# FIG.1

NONLINEAR CONTINUOUS-TIME SYSTEM

$$\dot{x} = f(t, x)$$
$$y = Cx$$

STATE ESTIMATION DEVICE
10

SYSTEM OUTPUT $y(t_k)$

$f$

STATE-AND-ERROR ESTIMATION UNIT ～1

ESTIMATED STATE VALUE $\widehat{x}_{k|k}$

STATE-EQUATION DISCRETIZATION UNIT ～2

$f_d(t_k, \widehat{x}_{k|k})$

STATE-EQUATION LINEARIZATION UNIT ～3

$F_k$

$\widehat{\Sigma}_{k|k}$

STATE-AND-ERROR PREDICTION UNIT ～4

$\widehat{x}_{k+1|k}$
$\widehat{\Sigma}_{k+1|k}$

# FIG.2

DISCRETE-TIME STATE EQUATION
$$f_d(t_k, \widehat{x}_{k|k})$$

3

STATE-EQUATION LINEARIZATION UNIT

$\epsilon$

STATE-AND-ERROR PREDICTION UNIT
4

$F_k$

6

ERROR PREDICTION UNIT

$\widehat{\Sigma}_{k|k}$

5

STATE PREDICTION UNIT

$\widehat{\Sigma}_{k+1|k}$

$\widehat{x}_{k+1|k}$

# FIG.3

SYSTEM OUTPUT $y(t_k)$
SYSTEM INPUT $u(t_k)$

# FIG.4

INITIALIZATION —S1

OBSERVA-
TION
EQUATION $\rightarrow$ CALCULATE KALMAN GAIN $K_k$ —S2

STATE-AND-
ERROR
ESTIMATION
UNIT 1

CALCULATE ESTIMATED ERROR COVARIANCE MATRIX VALUE $\widehat{\Sigma}_{k|k}$ —S3

SYSTEM
OUTPUT $\rightarrow$ CALCULATE ESTIMATED STATE VALUE $\widehat{x}_{k|k}$ —S4

ESTIMATED STATE VALUE $\widehat{x}_{k|k}$ OUTPUT

STATE
EQUATION
DISCRETIZA-
TION UNIT 2

SUBSTITUTE AS $x(t_k) = \widehat{x}_{k|k}$ —S5

STATE
EQUATION $\rightarrow$ QUADRATIC OR HIGHER-ORDER NUMERICAL INTEGRATION TECHNIQUE —S6

$i = 1$

INFIN-
ITESIMAL
SCALAR
VALUE $\rightarrow$ $\widehat{x}_i = \widehat{x}_{k|k} + \epsilon P_i \widehat{x}_{k|k}$ —S8

QUADRATIC OR HIGHER-ORDER NUMERICAL INTEGRATION TECHNIQUE —S9

STATE
EQUATION
LINEARIZA-
TION UNIT 3

CALCULATE $i$-TH COLUMN OF JACOBIAN APPROXIMATE VALUE USING DIFFERENCE METHOD —S10

$i++$

$i \leqq n$? —— YES

NO

STATE-AND-
ERROR
PREDICTION
UNIT 4

CALCULATE PREDICTED ERROR COVARIANCE MATRIX VALUE $\widehat{\Sigma}_{k+1|k}$ —S11

CALCULATE PREDICTED STATE VALUE $\widehat{x}_{k+1|k}$ —S7

$k++$

17

# FIG.5

STATE ESTIMATION
DEVICE
10A

OBSERVATION
EQUATION
$y = h(t, x)$

⌐7

OBSERVATION
EQUATION
LINEARIZATION UNIT

SYSTEM OUTPUT $y(t_k)$

NONLINEAR

CONTINUOUS-TIME STATE

EQUATION $\dot{x} = f(t, x)$

INFINITESIMAL SCALAR VALUE $\epsilon$

$H$

⌐10

STATE ESTIMATION
DEVICE

ESTIMATED
STATE VALUE
$\widehat{x}_{k|k}$

# FIG.6

INITIALIZATION ⌐S1

OBSERVATION
EQUATION
LINEARIZATION
UNIT 7

ANALYTICALLY CALCULATE
JACOBIAN $H$ OF
OBSERVATION EQUATION ⌐S21

SUBSTITUTE PREDICTED
STATE VALUE IN JACOBIAN
TO OBTAIN $H_k$ ⌐S22

S2~S11

$k++$

# FIG.7

STATE ESTIMATION
DEVICE
10B

OBSERVATION
EQUATION
$$y = h(t, x, u)$$

7

OBSERVATION-
EQUATION
LINEARIZATION UNIT

$H$  1

SYSTEM INPUT
AND OUTPUT
$u(t_k), y(t_k)$

STATE-AND-ERROR
ESTIMATION UNIT

ESTIMATED
STATE VALUE
$\widehat{x}_{k|k}$

NONLINEAR
CONTINUOUS-TIME
STATE EQUATION
$\dot{x} = f(t, x, u)$
SYSTEM INPUT $u(t_k)$

STATE-EQUATION
DISCRETIZATION UNIT

2

$f_d\left(t_k, \widehat{x}_{k|k}, u(t_k)\right)$

$\widehat{x}_{k+1|k}$

INFINITESIMAL
SCALAR VALUE $\epsilon$

STATE-
EQUATION
LINEARIZA-
TION UNIT

STATE
PREDICTION
UNIT

$\widehat{\Sigma}_{k|k}$   $F_k$

3

5

ERROR
PREDICTION
UNIT

$\widehat{\Sigma}_{k+1|k}$

6

# FIG.8

CONTINUOUS-TIME
MODELS CONTAINING
UNKNOWN
PARAMETER

STATE ESTIMATION
DEVICE
10C

$$\dot{x} = f(t, x, \theta)$$
$$y = h(t, x, \theta)$$

MODEL CONVERSION
UNIT ~8

NONLINEAR CONTINUOUS-
TIME MODELS
$$\dot{\tilde{x}} = \tilde{f}(t, \tilde{x})$$
$$y = h(t, \tilde{x})$$

SYSTEM OUTPUT $y(t_k)$

INFINITESIMAL
SCALAR VALUE $\epsilon$

STATE ESTIMATION
DEVICE ~10

ESTIMATED STATE VALUE $\hat{x}_{k|k}$
ESTIMATED PARAMETER VALUE $\hat{\theta}_{k|k}$

**INTERNATIONAL SEARCH REPORT**

International application No.

PCT/JP2017/021964

A. CLASSIFICATION OF SUBJECT MATTER
*G06F17/10*(2006.01)i, *G05B13/02*(2006.01)i

According to International Patent Classification (IPC) or to both national classification and IPC

B. FIELDS SEARCHED

Minimum documentation searched (classification system followed by classification symbols)
G06F17/10, G05B13/02

Documentation searched other than minimum documentation to the extent that such documents are included in the fields searched
Jitsuyo Shinan Koho         1922-1996   Jitsuyo Shinan Toroku Koho   1996-2017
Kokai Jitsuyo Shinan Koho   1971-2017   Toroku Jitsuyo Shinan Koho   1994-2017

Electronic data base consulted during the international search (name of data base and, where practicable, search terms used)

C. DOCUMENTS CONSIDERED TO BE RELEVANT

| Category* | Citation of document, with indication, where appropriate, of the relevant passages | Relevant to claim No. |
|---|---|---|
| A | JP 2013-36987 A  (Canon Inc.), 21 February 2013 (21.02.2013), paragraphs [0036] to [0079]; fig. 3 & US 2013/0010070 A1 paragraphs [0042] to [0074]; fig. 3 & CN 102914293 A | 1-6 |
| A | JP 2013-58105 A  (Kyushu Institute of Technology), 28 March 2013 (28.03.2013), paragraphs [0090] to [0107], [0122] (Family: none) | 1-6 |

☒  Further documents are listed in the continuation of Box C.     ☐  See patent family annex.

| * | Special categories of cited documents: | "T" | later document published after the international filing date or priority date and not in conflict with the application but cited to understand the principle or theory underlying the invention |
|---|---|---|---|
| "A" | document defining the general state of the art which is not considered    to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

Date of the actual completion of the international search
22 August 2017 (22.08.17)

Date of mailing of the international search report
29 August 2017 (29.08.17)

Name and mailing address of the ISA/
Japan Patent Office
3-4-3,Kasumigaseki,Chiyoda-ku,
Tokyo 100-8915,Japan

Authorized officer

Telephone No.

Form PCT/ISA/210 (second sheet) (January 2015)

EP 3 640 822 A1

**INTERNATIONAL SEARCH REPORT**

International application No.

PCT/JP2017/021964

C (Continuation). DOCUMENTS CONSIDERED TO BE RELEVANT

| Category* | Citation of document, with indication, where appropriate, of the relevant passages | Relevant to claim No. |
|---|---|---|
| A | FROGERAIS, Paul et al., Various Ways to Compute the Continuous-Discrete Extended Kalman Filter, IEEE Transactions on Automatic Control, 2012.04, Vol. 57, No. 4, pages 1000 - 1004, Electronic ISSN 1558-2523 | 1-6 |

Form PCT/ISA/210 (continuation of second sheet) (January 2015)

22

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2005248946 A

**Non-patent literature cited in the description**

- **TAKASHI YAHAGI.** Kalman Filter and Adaptive Signal Processing. Corona publishing, December 2005, 48-51